# EUROPÄISCHE PATENTSCHRIFT

(11) **EP 2 505 050 B1**
(45) Veröffentlichungstag und Bekanntmachung des Hinweises auf die Patenterteilung: **10.01.2018**
(21) Anmeldenummer: 10776584.4
(22) Anmeldetag: 03.11.2010
(51) Int. Cl.: H05K 7/14

(54) **GEHÄUSESYSTEM**
HOUSING SYSTEM
SYSTÈME DE BOÎTIER

(30) Priorität: 25.11.2009 DE 102009054439
(43) Veröffentlichungstag der Anmeldung: 03.10.2012
(73) Patentinhaber: SEW-EURODRIVE GmbH & Co. KG, 76646 Bruchsal (DE)
(72) Erfinder: HUBER, Martin, 77830 Bühlertal (DE); JUNGINGER, Alexander, 75196 Remchingen-Wilferdingen (DE); KARST, Andreas, 75239 Eisingen (DE)
(74) Vertreter: Tüngler, Eberhard
(86) Internationale Anmeldenummer: PCT/EP2010/006687
(87) Internationale Veröffentlichungsnummer: WO 2011/063885

(56) Entgegenhaltungen:
- DE-U1- 7 820 391
- US-A- 4 401 351
- US-A- 4 597 291
- US-A1- 2005 189 889
- US-A1- 2009 023 320
- US-B1- 6 640 235

## Beschreibung

Die Erfindung betrifft ein Gehäusesystem.

Aus der DE 10 2004 034 834 ist ein Gehäusesystem bekannt.

**Aus der** US 2009/023320 A1 **ist ein elektrisches modulares Bussystem bekannt. Aus der** US 4 597 291 A **ist ein modulares Gehäusesystem bekannt, das aus miteinander verbindbaren Teilen besteht.**

**Aus der** US 6 640 235 B1 **ist ein expandierbares Speichersystem für Scheiben bekannt, wobei Gehäuseteile modular aneinander anfügbar sind.**

**Aus der** US 4 401 351 A **ist ein expandierbares Kartengehäuse bekannt, wobei ebenfalls Gehäusemodule aneinander anfügbar sind.**

**Aus der** US 2005/189889 A1 **ist ein modular aufgebautes Steuersystem für einen Wechselstrommotor bekannt.**

Aus der DE78 20 391 U1 ist die schwimmende Lagerung einer Leiterplatte in einem Vorrichtungsgehäuse bekannt.

Der Erfindung liegt daher die Aufgabe zugrunde, ein Gehäusesystem weiterzubilden, wobei das Gehäusesystem einfach zusammenbaubar sein soll.

Erfindungsgemäß wird die Aufgabe bei der nach den in Anspruch 1 angegebenen Merkmalen gelöst.

Wichtige Merkmale der Erfindung bei dem Gehäusesystem sind, dass das Gehäusesystem mindestens zwei Gehäuseteile mit je einem zugehörigen Gehäusedeckel umfasst, wobei jedes der Gehäuseteile wannenförmig ausgeformt ist, wodurch das Gehäuseteil und der zugehörige Gehäusedeckel je einen Innenraum einfassen, und je zwei Gehäuseteile über eine Vorrichtung zur elektrischen Verbindung, welche als Steckmodul mit einem ersten und zweiten Steckverbinderteil ausgeführt ist, elektrisch und/oder mechanisch lösbar verbunden sind. Von Vorteil ist dabei, dass das Gehäusesystem einfach, flexibel und sicher zusammenbaubar ist.

Bei einer vorteilhaften Ausgestaltung weist die Vorrichtung zur elektrischen Verbindung ein erstes Steckverbinderteil und ein zweites Steckverbinderteil auf, welche mit je einem von außen zugänglichen Kontaktbereich in einem Vorrichtungsgehäuse angeordnet sind, wobei das erste Steckverbinderteil mit einer ersten Leiterplatte fest verbunden ist und das zweite Steckverbinderteil mit einer zweiten Leiterplatte fest verbunden ist, wobei die erste Leiterplatte und die zweite Leiterplatte jeweils im Vorrichtungsgehäuse und relativ zum Vorrichtungsgehäuse beweglich angeordnet sind und somit jeweils eine Beweglichkeit im Vorrichtungsgehäuse aufweisen. Von Vorteil ist dabei, dass die Gehäuseteile einfach miteinander verbindbar sind, wobei eine hohe Toleranz ausgleichbar ist.

Bei einer weiteren vorteilhaften Ausgestaltung weisen die Gehäuseteile einen Boden und eine erste Seitenwand und eine der ersten Seitenwand gegenüberliegende zweite Seitenwand sowie eine die erste und zweite Seitenwand verbindende Frontseite und eine entsprechende der Frontseite gegenüberliegende Rückseite auf. Von Vorteil ist dabei, dass die Gehäuseteile flexibel miteinander verbindbar sind.

Bei einer weiteren vorteilhaften Ausgestaltung sind in der Rückseite des oder der Gehäuseteile Öffnungen angeordnet, welche vorzugsweise in an den Seitenwänden angrenzenden Endbereichen der Rückseite angeordnet. Von Vorteil ist dabei, dass die Gehäuseteile flexibel miteinander verbindbar sind.

Bei einer weiteren vorteilhaften Ausgestaltung sind am Vorrichtungsgehäuse zwei Einführhilfen angeformt, in welchen die ersten und zweiten und/oder ein drittes und ein viertes Steckverbinderteile zumindest teilweise in passenden Ausnehmungen beweglich angeordnet sind. Von Vorteil ist dabei, dass das Gehäusesystem flexibel und einfach zusammenbaubar ist und eine sicherer elektrische Verbindung zwischen den Gehäuseteilen herstellbar ist.

Bei einer weiteren vorteilhaften Ausgestaltung greifen im eingesteckten Zustand der Vorrichtung zur elektrischen Verbindung die Einführhilfen in die Öffnungen zweier benachbarter Gehäuseteile annähernd formschlüssig ein und das Vorrichtungsgehäuse verschließt die Öffnungen abdichtend. Von Vorteil ist dabei, dass ein sicherer Verbindung zwischen den Gehäuseteilen herstellbar ist und das Gehäusesystem in hoher Schutzart flexibel zusammenbaubar ist.

Bei einer weiteren vorteilhaften Ausgestaltung ist die erste Leiterplatte mit der zweiten Leiterplatte im Vorrichtungsgehäuse mittels elektrischen Leitungen, insbesondere einem Flachbandkabel, verbunden, wobei eine relative Beweglichkeit der ersten Leiterplatte zur zweiten Leiterplatte im Vorrichtungsgehäuse durch die elektrischen Leitungen gedämpft und/oder uneingeschränkt ist. Von Vorteil ist dabei, dass die erste und zweite Leiterplatte im Vorrichtungsgehäuse weniger hin und her schlackern. Die Einsteckbarkeit in die Gehäuseteile ist verbessert und somit das Gehäusesystem einfacher zusammenbaubar.

Bei einer weiteren vorteilhaften Ausgestaltung sind das dritte Steckverbinderteil auf einer dritten Leiterplatte und das vierte Steckverbinderteil auf einer vierten Leiterplatte im Vorrichtungsgehäuse angeordnet, wobei je ein Kontaktbereich des dritten und vierten Steckverbinderteils von außerhalb des Vorrichtungsgehäuses zugänglich ist und die dritte und vierte Leiterplatte im Vorrichtungsgehäuse jeweils eine Bewegbarkeit aufweisen und über weitere elektrische Leitungen, insbesondere einzelne Kupferdrähte, miteinander verbunden sind, insbesondere so dass eine relative Bewegbarkeit zwischen der dritten und vierten Leiterplatte gedämpft und/oder uneingeschränkt ist. Von Vorteil ist dabei, dass das Gehäusesystem mit einer hohen Varianz einfach zusammenbaubar ist.

Bei einer weiteren vorteilhaften Ausgestaltung greifen das erste und zweite Steckverbinderteil und/oder das dritte und vierte Steckverbinderteil jeweils in ein passendes Gegensteckverbinderteil in jeweils benachbarten Gehäuseteilen ein. Von Vorteil ist dabei, dass sicher und einfach eine elektrische Verbindung zwischen den Gehäuseteilen herstellbar ist.

Bei einer weiteren vorteilhaften Ausgestaltung sind hinter den jeweils zwei Öffnungen in den jeweiligen Innenräumen die passenden Gegensteckverbinderteile angeordnet, wobei die Gegensteckverbinderteile in den jeweiligen Innenräumen über eine Rückplatte miteinander verbunden sind. Von Vorteil ist dabei, dass elektrische Verbindungen zwischen den Gehäuseteilen einfach durchgeschleift sind und somit einfach und sicher alle nötigen elektrischen Signale in allen Gehäuseteilen flexibel zur Verfügung stehen.

Bei einer weiteren vorteilhaften Ausgestaltung sind das erste und zweite Steckverbinderteil zur Übertragung von Datensignalen im Kleinspannungsbereich ausgeführt sowie das dritte und vierte Steckverbinderteil sind zur Übertragung von elektrischer Leistung im Niedervoltbereich ausgeführt. Von Vorteil ist dabei, dass die Signale getrennt sind und somit eine elektrische Verbindung verschiedener Signale einfach und sicher zwischen den Gehäuseteilen herstellbar ist.

Bei einer weiteren vorteilhaften Ausgestaltung sind je zwei Gehäuseteile über Ausformungen an Einem der zwei Gehäuseteile und dazu komplementäre Ausformungen am Anderen der zwei Gehäuseteile miteinander mechanisch verbunden. Von Vorteil ist dabei, dass die Gehäuseteile einfach uns sicher mechanisch miteinander verbindbar sind und die elektrische Verbindung mechanisch entlastet ist und somit sicherer ist.

Bei einer weiteren vorteilhaften Ausgestaltung sind die erste und zweite Leiterplatte beziehungsweise die dritte und vierte Leiterplatte im Vorrichtungsgehäuse durch entsprechende Haltemittel in ihrer Beweglichkeit beziehungsweise Bewegbarkeit beschränkt. Von Vorteil ist dabei, dass ein sicheres Einstecken gewährleistet ist und eine hohe Toleranz ausgleichbar ist.

Bei einer weiteren vorteilhaften Ausgestaltung sind in der Frontseite durchgehende Ausnehmungen angeordnet, in welchen insbesondere passende Steckverbinderteile angeordnet sind und vorzugsweise sind die erste und zweite Leiterplatte in einer ersten Ebene im Vorrichtungsgehäuse angeordnet und die dritte und vierte Leiterplatte sind in einer zweiten Ebene im Vorrichtungsgehäuse angeordnet, wobei die erste Ebene parallel beabstandet zur zweiten Ebene liegt. Von Vorteil ist dabei, dass die Signale getrennt im Vorrichtungsgehäuse verlaufen und sich wenig beeinflussen.

Bei einer weiteren vorteilhaften Ausgestaltung weist die Frontseite und die Rückseite in einem bodenseitigen der ersten Seitenwand zugewandten Eckbereich je eine Hakenelement auf, welches über die erste Seitenwand übersteht und in einem bodenseitigen der zweiten Seitenwand zugeordneten Eckbereich eine senkrecht auf der Frontseite beziehungsweise der Rückseite abstehendes Zapfenelement aufweist, wobei im zusammengebauten Zustand der mehreren Gehäuseteile das Hakenelement in das jeweilig zugeordnete Zapfenelement des benachbarten Gehäuseteils eingreift. Von Vorteil ist dabei, dass die Gehäuseteile sicher, einfach und flexibel miteinander verbindbar sind.

Die Erfindung wird nun anhand von Ausführungsbeispielen mit Bezugnahme auf die Zeichnung näher erläutert. Es zeigen rein schematisch:
- Fig. 1:: eine dreidimensionale Explosionsdarstellung eines erfindungsgemäßen Gehäusesystems;
- Fig. 2:: eine dreidimensionale Draufsicht einer weiteren Ausführungsform eines erfindungsgemäßen Gehäusesystems;
- Fig. 3:: eine Seitenansicht des in Figur 2 gezeigten Gehäusesystems; und
- Fig. 4:: eine dreidimensionale Ansicht eines einzelnen Moduls eines erfindungsgemäßen Gehäusesystems.
- Fig.5:: eine dreidimensionale Unteransicht einer Vorrichtung zur elektrischen Verbindung;
- Fig.6:: eine dreidimensionale Draufsicht der in Figur 1 gezeigten Vorrichtung zur elektrischen Verbindung;
- Fig.7:: eine Unteransicht der in Figur 1 gezeigten Vorrichtung zur elektrischen Verbindung;
- Fig. 8:: einen Schnitt durch die in Figur 1 gezeigte Vorrichtung zur elektrischen Verbindung; und
- Fig.9:: eine dreidimensionale Ansicht eines Schnitts durch eine weitere Ausführungsform einer Vorrichtung zur elektrischen Verbindung.

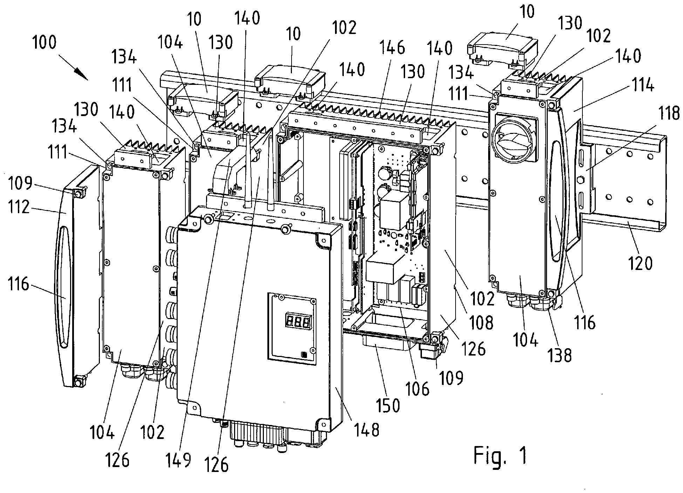

Die Figur 1 zeigt ein erfindungsgemäßes Gehäusesystem 100 in einer dreidimensionalen Explosionsdarstellung. Das Gehäusesystem 100 ist insbesondere als Gehäuse für eine elektrische Vorrichtung, vorzugsweise einen Umrichter zur Ansteuerung eines Elektromotors, geeignet ist und gebraucht wird.

Das Gehäusesystem 100 umfasst mindestens zwei Gehäuseteile 102 mit je einem zugehörigen Gehäusedeckel 104. Ein Gehäuseteil 102 fasst mit dem zugehörigen Gehäusedeckel 104 je einen Innenraum 106 ein. Somit bildet jedes Gehäuseteil 102 mit seinem Gehäusedeckel 104 und eventuellen Anbauteilen ein abgeschlossenes Einzelgehäuse. In diesen Einzelgehäusen sind verschiedene Module der elektrischen Vorrichtung angeordnet. Zum Beispiel gibt es bei einem Gehäusesystem 100 für einen Umrichter ein Gleichrichtermodul, ein Wechselrichtermodul, ein Einschaltmodul und so weiter.

Jedes der Gehäuseteile 102 ist wannenförmig ausgeformt. Das Gehäuseteil 102 ist durch den Gehäusedeckel 104 dicht und/oder berührgeschützt abgeschlossen. Somit kann jedes Einzelgehäuse des Gehäusesystems 100 und somit jedes Modul der elektrischen Vorrichtung einzeln montiert und überprüft werden. Die einzelnen Module sind vorteilhafterweise derart abgeschlossen, dass die Module einzeln abgenommen werden können, das heißt zum Beispiel nach VDE-Normen abgenommen sind. Dies hat den weiteren Vorteil, dass das Gehäusesystem 100 als Ganzes nicht mehr abgenommen beziehungsweise überprüft werden muss. Jedes beliebige Gehäusesystem 100, welches aus den Gehäuseteilen 102 mit zugehörigen Gehäusedeckel 104 aufgebaut ist, weist automatisch die entsprechende Sicherheitsnorm der Einzelgehäuse beziehungsweise Module auf.

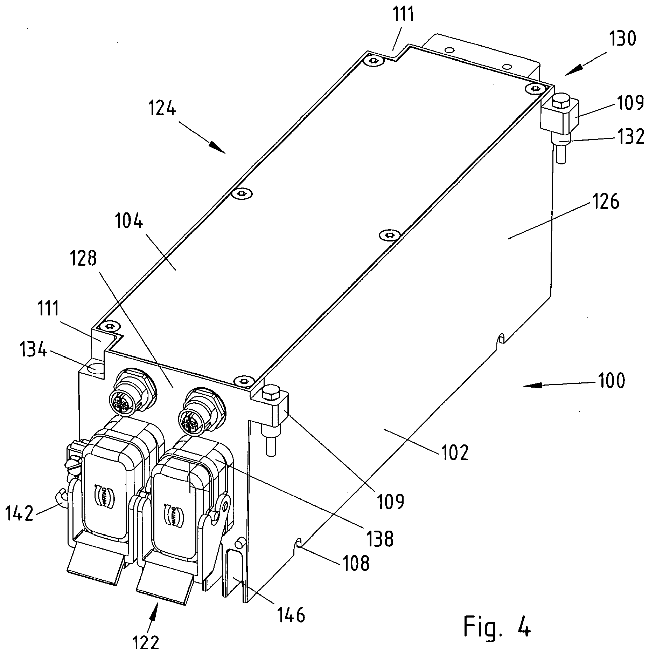

Die in den Figuren 1 bis 4 gezeigten Gehäuseteile 102 weisen einen Boden 122 auf. Mit dem Boden 122 ist eine Gehäusewand einstückig verbunden. Die Gehäusewand besteht aus einer erste Seitenwand 124 und einer der ersten Seitenwand 124 gegenüberliegende zweite Seitenwand 126. Die erste und zweite Seitenwand 124, 126 sind durch eine Frontseite 128 und eine der Frontseite 128 gegenüberliegende Rückseite 130 miteinander verbunden.

An dem Boden 122 sind außerhalb des Innenraums liegende Kühlelemente angeformt. Die Kühlelemente sind vorzugsweise als zu der ersten und zweiten Seitenwand 124, 126 parallel angeordnete Kühlrippen 146 ausgebildete. In einer alternativen Ausführungsform sind auch zum Beispiel Kühlfinger als Kühlelement möglich.

Mit den Kühlrippen 146 sind insbesondere elektronische Bauelemente, wie Dioden oder Transistoren, insbesondere IGBTs oder Thyristoren, über den Boden 122 thermisch verbunden. Dafür sind vorzugsweise zwischen dem elektronischen Bauelement und dem Boden 122 Materialien mit einer Wärmeleitfähigkeit von größer als 4 W/(m K) angeordnet. Der Boden 122 mit den Kühlrippen 146 beziehungsweise das Gehäuseteil 102 ist vorzugsweise aus einem Material mit einer thermischen Leitfähigkeit von größer als 15 W/(m K) insbesondere von größer als 100 W/(m K) gefertigt.

Der Boden 122 weist bei einer bevorzugten Ausführungsform Aufnahmeausformungen auf, um elektronische Bauelement, wie zum Beispiel Kondensatoren oder IGBTs sicher zu platzieren und zu befestigen. Weiter erlauben die Aufnahmeausformungen eine bessere Entwärmung der elektronischen Bauteile. Bei weiteren Ausführungsformen sind an dem Boden senkrecht abstehende Abstandszapfen 123 angeformt. Auf den Abstandzapfen 123 sind vorzugsweise Leiterplatten angebracht. Dazu weisen die Abstandszapfen 123 vorzugsweise Gewindebohrungen auf, so dass die Leiterplatten an den Abstandszapfen 123 angeschraubt sind.

Die erste und zweite Seitenwand 124, 126 sind vorzugsweise über den Boden 122 hinaus als je einer der Kühlrippen 146 verlängert.

Bei einer nicht gezeigten weiteren Ausführungsform der Erfindung ist am Boden eine Halterung für eine Kühler angeformt, so dass ein in der Halterung montierter Kühler eine Luftstrom über die Kühlelemente bewirkt.

Die erste und zweite Seitenwand 124, 126, die Frontseite 128 und die Rückseite 130 bilden zum Deckel hin freistehende Endbereiche. Die freistehenden Endbereiche bilden eine umlaufende Stufe, auf welche der Gehäusedeckel 104 bündig mit den deckelseitigen Enden der Gehäusewand aufgelegt ist. In die Stufe ist eine Dichtung eingelassen vorzugsweise angespritzt oder eingespritzt. Der Gehäusedeckel 104 wird mittels Befestigungselementen gegen die Dichtung gedrückt. Als Befestigungselement sind vorzugsweise Schrauben, insbesondere Senkkopfschrauben, durch passende Schraubenöffnungen im Gehäusedeckel 104 geführt und in entsprechend angeordnet Gewindelöcher in der Gehäusewand eingeschraubt. Eine Höhe des Gehäuseteils 102 ergibt sich aus dem maximalen Abstand zwischen einem freistehenden Ende einer der Kühlelemente und einer umlaufenden Stirnfläche der Gehäusewand, welche bündig mit dem Gehäusedeckel 104 ist.

Damit das Gehäusesystem 100 möglichst einfach und sicher aus den Gehäuseteilen 102 aufgebaut werden kann, sind an jedem Gehäuseteil 102 Ausformungen 108, 109 und zu den Ausformungen 108, 109 komplementäre Ausformungen 110, 111 ausgebildet. Je zwei Gehäuseteile 102 lassen sich mittels der Ausformungen 108, 109 des Einen der zwei Gehäuseteile 102 und den komplementären Ausformungen 110, 111 des Anderen der zwei Gehäuseteile 102 miteinander mechanisch und/oder elektrisch, lösbar verbinden. Die Verbindung zwischen den Gehäuseteilen 102 ist vorzugsweise formschlüssig und/oder kraftschlüssig. Die Gehäuseteile 102 sind vorteilhafterweise so miteinander verbunden, dass die erste Seitenwand 124 des einen Gehäuseteils 102 der zweiten Seitenwand 126 des anderen Gehäuseteils 102 direkt gegenüberliegt und/oder zumindest teilweise berührt.

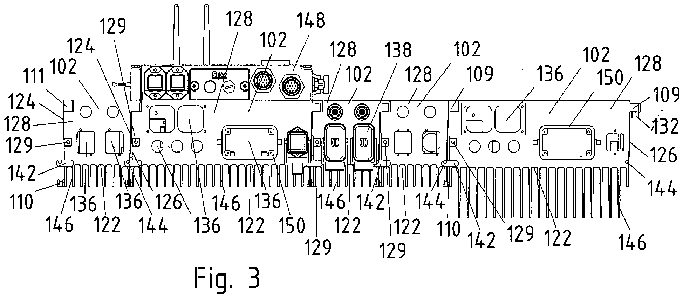

In der in Figur 3 gezeigten Ausführungsform ist eine erste Art von Ausformungen 108 als in Richtung vom Boden 122 zum Gehäusedeckel 104 her offener Einschnitt ausgebildet. Der Einschnitt ist an der bodenseitigen Kante der zweiten Seitenwand 126 beziehungsweise in einem freistehenden Endbereich der als Verlängerung der zweiten Seitenwand 126 ausgebildeten Kühlrippe eingebracht.

Mit der ersten Art von Ausformungen 108 wirkt eine erste Art von komplementären Ausformungen 110 zusammen, um jeweils zwei Gehäuseteil 102 miteinander zu verbinden. Die erste Art von komplementären Ausformungen 110 ist als seitlich vorstehendes Eingreifelement ausgebildet. Das Eingreifelement ist an der bodenseitigen Kante der ersten Seitenwand 124 beziehungsweise in einem freistehenden Endbereich der als Verlängerung der ersten Seitenwand 124 ausgebildeten Kühlrippe angeordnet. Das Eingreifelement steht vorzugsweise senkrecht zur ersten Seitenwand 124 in die vom Gehäuseteil 102 abgewandte Richtung ab.

Die erste Art von komplementären Ausformungen 110 ist vorteilhafterweis als ein eckiges Hakenelement ausgeführt, welches formschlüssig in den Einschnitt in der zweiten Seitenwand 126 des einen Gehäuseteils 102 der jeweils zwei Gehäuseteile 102 eingreift. Dabei hintergreift ein Teilabschnitt des Hakenelementes die Kühlrippe, welche als Verlängerung der zweiten Seitenwand 126 des einen Gehäuseteils 102 ausgeführt ist.

Zur weiteren Verbindung zwischen den jeweils zwei Gehäuseteilen 102 ist eine zweite Art von Ausformungen 109 im Bereich einer deckelseitigen Kante ausgebildet. Die zweite Art von Ausformungen 109 ist vorzugsweise als quaderförmiger Vorsprung ausgebildet, welcher an der zweiten Seitenwand 126 angeformt ist und von dieser senkrecht absteht. Eine Fläche des quaderförmigen Vorsprungs geht insbesondere bündig in die Frontseite 128 beziehungsweise die Rückseite 130 des Gehäuseteils 102 über. Vorzugsweise sind mindestens zwei quaderförmige Vorsprünge an der zweiten Seitenwand 126 angeordnet, wobei ein quaderförmiger Vorsprung in einem Eckbereich zur Frontseite 128 und ein weiterer quaderförmiger Vorsprung in einem Eckbereich zur Rückseite 130 hin an der zweiten Seitenwand 126 angeformt sind.

Die zweite Art von Ausformungen 109 wirken im zusammengebauten Zustand mit einer zweiten Art von komplementären Ausformungen 111 zusammen. Die zweite Art von komplementären Ausformungen 111 ist als zu den quaderförmigen Vorsprüngen komplementäre quaderförmige Eindellungen ausgebildet. Die quaderförmigen Eindellungen sind entsprechen in Bereichen, einer deckelseitigen Kante der zweiten Seitenwand 126 angeordnet. Vorzugsweise sind die Eindellungen in Eckbereichen zur Frontseite 128 beziehungsweise Rückseite 130 hin angeordnet. Die Eindellungen bilden so drei Flächen eines Quaders. Die restlichen Flächen des Quaders sind nicht vorhanden, d.h. die quaderförmigen Eindellungen sind aus drei Richtungen vollflächig zugänglich.

Zur weiteren Fixierung der quaderförmigen Vorsprünge mit den quaderförmigen Eindellungen weisen die quaderförmigen Vorsprünge vorzugsweise eine bodenseitige Ausstülpung 132 auf. Diese Ausstülpung 132 greift im zusammengebauten Zustand der Gehäuseteile 102 in eine korrespondierende Ausnehmungen 134 in einer bodenseitigen Fläche der Eindellungen ein. Somit ist die zweite Art von Ausformungen 109 formschlüssig mit der zweiten Art von komplementären Ausformungen 111 verbunden.

Zur weiteren Sicherung der Verbindung zwischen zwei benachbarten Gehäuseteilen 102 ist ein Sicherungsmittel, insbesondere eine Schraube, durch die quaderförmige Ausstülpung hindurchgeführt und in einem in oder unterhalb der korrespondierenden Ausnehmung 134 angeordneten Befestigungsmittel, insbesondere Gewindeloch, befestigt.

Die mechanischen Verbindungen mittels der Ausformungen 108, 109 und den komplementären Ausformungen 110, 111 insbesondere als Schraubverbindungen erlauben auch einen elektrischen Potentialausgleich zwischen den Gehäuseteilen 102. Dies erlaubt einen einzigen Schutzleiteranschluss für das Gehäusesystem 100. Zum Schutzleiteranschluss weist das Gehäuseteil 102 an der Frontseite 128 eine vorzugsweise quaderförmige Ausstülpung auf, welche Senkrecht von der Frontseite 128 absteht. Von einer freistehenden Stirnfläche aus ist in die quaderförmige Ausstülpung eine Gewindebohrung eingearbeitet.

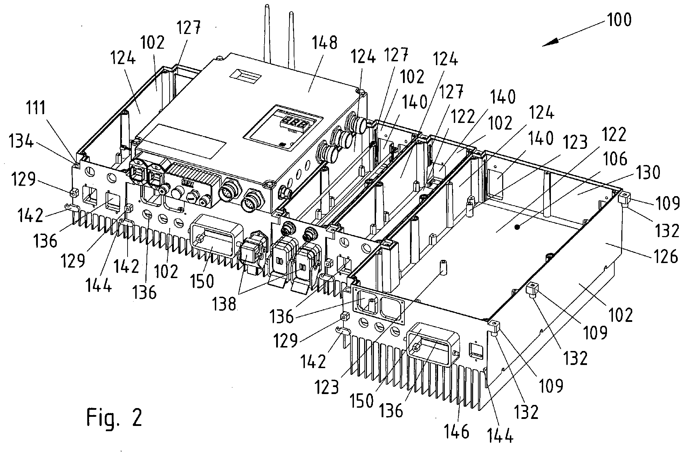

Bei größeren Ausführungsformen der Gehäuseteile 102, d.h. mit längeren ersten und zweiten Seitenwänden 124, 126, wie zum Beispiel auch in der Figur 2 ganz rechts zu sehen, sind zusätzliche Ausformungen 108, 109 und zusätzliche komplementäre Ausformungen 110, 111 angebracht. Dies erlaubt vor allem die sichere und stabile Zusammenbaubarkeit, d.h. Kompatibilität, dieser größeren Ausführungsform der Gehäuseteile 102 mit kleineren Ausführungsformen der Gehäuseteile 102.

In der Frontseite 128 sind durchgehende Ausnehmungen 136 angeordnet oder eingebracht. Die durchgehenden Ausnehmungen 136 sind entweder bei einem Gießprozess zur Herstellung des Gehäuseteils 102 mit entsprechenden Formmitteln direkt gefertigt oder nachträglich eingebracht, insbesondere gebohrt oder gefräst. Die durchgehenden Ausnehmung 136 dienen unter anderem als Kabeldurchführung in dem passende Steckverbinderteile in den durchgehenden Ausnehmungen 136 angeordnet insbesondere angeschraubt sind. Vorteilhafterweise ist zumindest bei einem der Gehäuseteile 102 ein Gehäuse 150 für ein Anschlusssteckverbinderteil um eine der durchgehenden Ausnehmung 136 einstückig angeformt, insbesondere angegossen. Die passenden Steckverbinderteile verschließen die durchgehenden Ausnehmungen 136 vorzugsweise abdichtend, insbesondere gemäß einer bekannten Schutzklasse wie zum Beispiel IP65 oder IP54.

In der Rückseite 130 des oder der Gehäuseteile 102 ist eine Öffnungen 140 angeordnet. Vorzugsweise sind je zwei der Öffnungen 140 in den Rückseiten 130 der Gehäuseteile102 in an die erste und zweite Seitenwand 124, 126 angrenzenden Endbereichen angeordnet. Die Öffnungen 140 weisen insbesondere identische Ausmaße auf und haben zur jeweils nächstliegenden ersten oder zweiten Seitenwand 124, 126 denselben Abstand.

Um die einzelnen in den Innenräumen 106 der Gehäuseteilen 102 angeordneten Module der elektrischen Vorrichtung funktional, das heißt insbesondere elektrisch miteinander zu verbinden, sind je zwei Gehäuseteile 102 über eine Vorrichtung 10 zur elektrischen Verbindung elektrisch und/oder mechanisch lösbar verbunden. Die Vorrichtung 10 zur elektrischen Verbindung ist vorzugsweise als Steckmodul mit einem ersten und zweiten Steckverbinderteil ausgeführt.

Zwei zu den Öffnungen 140 passend ausgeführt Einführhilfen der Vorrichtung 10 zur elektrischen Verbindung greifen in je eine Öffnung 140 zweier benachbarter Gehäuseteile 102 ein. Im Innenraum 106 des jeweiligen Gehäuseteils 102 ist je ein Gegensteckverbinderteil angeordnet in dem je eines der ersten und zweiten Steckverbinderteile der Vorrichtung 10 zur elektrischen Verbindung eingesteckt ist.

Dadurch werden je zwei der einzelnen in sich abgeschlossenen, jeweils eine elektrische Funktionalität aufweisenden Gehäuseteile 102 miteinander elektrisch Verbunden. Vorzugsweise sind die Vorrichtungen 10 zur elektrischen Verbindung die Öffnungen 140 Abdichtend angebracht, insbesondere angeschraubt. Durch diese dichtende, feste Verbindung sind die jeweils benachbarten Gehäuseteile 102 auch mechanisch miteinander verbunden.

Vorzugsweise sind die Gegensteckverbinderteile an eine Leiterplatte angeordnet. Die Leiterplatte ist vorzugsweise als Rückplatte, beziehungsweise in der Fachsprache als Backplane bekannt, ausgeführt. Dadurch lassen sich verschiedene elektrische Verbindungen auf einfache und sichere Art und Weise auch bei mehreren Gehäuseteilen 102 leicht zusammenbaubar durchschleifen. Somit sind vorteilhafterweise alle elektrischen Signale einer Rückplatte eines bestimmten Gehäuseteils 102 in allen Gehäuseteilen 102 verfügbar. Die Rückplatten sind in sich im Innenraum 106 gegenüberliegenden Haltevorrichtungen angeordnet. Die Haltevorrichtungen sind vorzugsweise als Einschubkanäle 127 ausgeführt, so dass die Rückplatten einfach von der offenen Seite der Gehäuseteile 102 in den Innenraum 106 eingeschoben werden und vom Gehäusedeckel 104 fixiert sind.

Als zusätzliche mechanische Verbindungselemente weisen bei den in den Figuren 1 bis 4 gezeigten Gehäuseteile 102 die jeweiligen Frontseiten 128 in einem bodenseitigen der ersten Seitenwand 124 zugewandten Eckbereich je ein Hakenelement 142 auf. Das Hakenelement 142 steht über die jeweilige erste Seitenwand 124 über. Mit dem Hakenelement 142 wirkt ein Zapfenelement 144 zusammen. Das Zapfenelement 144 ist in einem bodenseitigen der zweiten Seitenwand 126 zugeordneten Eckbereich senkrecht auf der Frontseite 128 angeordnet. Im zusammengebauten Zustand der mehreren Gehäuseteile 102 greift das Hakenelement 142 in das jeweilig zugeordnete Zapfenelement 144 des benachbarten Gehäuseteils 102 ein.

Das Gehäusesystem 100 ist an einen Vorrichtung oder Maschine direkt befestigbar oder an eine allgemeine bekannte Haltevorrichtung, wie zum Beispiel eine Hutschiene, eine G-Schiene oder eine in Figur 1 gezeigte C-Schiene 120 befestigbar.

Zu diesem Zwecke weist das Gehäusesystem 100 ein erstes und ein zweites Halteelement 112, 114 auf. An den Haltelementen 112, 114 ist ein Befestigungselement 118 ausgeformt, mit welchem das erste und zweite Halteelement 112, 114 in die entsprechende Haltevorrichtung eingreift. Das Befestigungselement 118 ist komplementär zur Haltevorrichtung ausgeformt.

Das erste Halteelement 112 weist die Ausformungen 108, 109 auf und das zweite Halteelement 114 die komplementären Ausformungen 110, 111. Somit ist das erste Haltemittel 112 mit dem Gehäuseteil 102 über dessen komplementäre Ausformungen 110, 111 mechanisch verbunden. Das zweite Haltemittel 114 ist an dem Gehäuseteil 102 oder einem weiteren Gehäuseteil 102 über dessen Ausformungen 108, 109 mechanisch verbunden.

Da das erste und zweite Haltelement 112, 114 nur an einer Seite die Ausformungen 108, 109 oder die komplementären Ausformungen 110, 111 aufweisen, sind die Halteelemente auch als Abschlusselemente ausgeführt an die keine weiteren Gehäuseteile 102 anfügbar sind.

Vorzugsweise sind die insbesondere quaderförmigen Gehäuseteile 102 entlang einer Achse aufgereiht miteinander verbunden. Das erste und zweite Halteelement 112, 114 bilden somit entlang dieser Achse Abschlusselemente des Gehäusesystems 100.

Zur besseren Handhabbarkeit des Gehäusesystems 100 weist das erste und zweite Halteelement 112, 114 je eine Ausnehmung 116 auf. Die Ausnehmung 116 ist in einer deckelseitigen Auskragung in Richtung weg vom Gehäuseteil 102 des Halteelementes 112, 114 angeordnet. Vorzugsweise ist die Ausnehmung 116 ellipsenförmig. Die Ausmaße der Ausnehmung 116 ist vorteilhafterweise so ausgeführt, dass zumindest die Finger einer menschliche Hand oder ein Befestigungs- oder Kranhaken die Ausnehmung durchdringen kann. So ist das Gehäusesystem 100 mittels zwei Händen von einer Person einfach und sicher bewegbar.

Ein weiterer Gehäusedeckel 148 ist wannenförmig ausgeführt und mit seiner Öffnung auf einem Passenden der Gehäuseteile 102 angeordnet ist, wodurch ein weiterer Innenraum gebildet ist. Der weitere Gehäusedeckel 148 schließt entweder zusammen mit dem Passenden der Gehäuseteile 102, auf welchem der weitere Gehäusedeckel 148 befestigt ist, einen gemeinsamen Innenraum ein oder der Gehäusedeckel 104 des Passenden der Gehäuseteile 102 trennt den Innenraum 106 des Passenden der Gehäuseteils 102 von einem weiteren Innenraum des weiteren Gehäusedeckei 148 ab.

In letzterem Fall ist an der Rückseite 130 des Passenden der Gehäuseteile 102 und der entsprechenden Rückseite des weiteren Gehäusedeckels 148 ein Verbindungselement 149 zur elektrischen Verbindung angebracht, welches in ähnlicher Art und Weise wie die Vorrichtung 10 zur elektrischen Verbindung die elektrischen und elektronischen Komponenten im weiteren Gehäusedeckel 148 mit den elektrischen und /oder elektronischen Komponenten in dem Passenden der Gehäuseteile 102 elektrisch verbindet.

Vorzugsweise ist diese elektrische Verbindung ebenfalls über die Backplane bzw. Rückplatte im Passenden der Gehäuseteile 102 realisiert, so dass elektrische Signale der Komponenten im weiteren Gehäusedeckel 148 auf einfache Art und Weise in jedem der Gehäuseteile 102 zur Verfügung stehen.

In einer nichtgezeigten Ausführungsform ist diese elektrische Verbindung durch eine durchgehende Aussparung im Gehäusedeckel 104, vorzugsweise als Steckverbindung ausgebildet, so dass der weitere Gehäusedeckel 148 mittels der Steckverbindung auf das Passende der Gehäuseteile 102 aufgesteckt wird und anschließend mit weiteren Befestigungsmitteln am Passenden der Gehäuseteile 102 befestigt.

Im weiteren Gehäusedeckel 148 ist vorzugsweise die Ansteuerungselektronik, wie eine speicherprogrammierbare Steuerung oder ein eventuell notwendige Sicherheitssteuerung zu sicheren Überwachung der Ansteuerung angeordnet. Dadurch sind die empfindlicheren elektronischen Bauteile von eventuell größeren Wärmemengen erzeugender Bauteile des in den Gehäuseteile 102 untergebrachten Umrichterelektronik besser getrennt.

Bei einer bevorzugten Ausführungsform ist in dem weiteren Gehäusedeckel 148 eine Kommunikationselektronik angeordnet, welche mit am weiteren Gehäusedeckel 148 angebracht Antennen verbunden ist. Der weitere Gehäusedeckel weist bevorzugterweise eine von außerhalb sichtbare Anzeigevorrichtung auf. Die Anzeigevorrichtung ist vorzugsweis in einer Durchgangsöffnung des weiteren Gehäusedeckels 148 angebracht.

Alternativ lassen sich die Ansteuerungselektronik und die Sicherungselektronik in einem gemeinsamen oder in je einem Gehäuseteil 102 mit passendem Gehäusedeckel 104 unterbringen. In dieser weiteren Ausführungsform ist das Gehäusesystem nur aus Gehäuseteilen 102 mit entsprechendem Gehäusedeckel 104 und den Halteelementen 112, 114 sowie den entsprechenden Vorrichtungen zur elektrischen Verbindung aufgebaut.

Der weitere Gehäusedeckel 148 oder das entsprechende Gehäuseteil 102 weist vorzugsweise Anschlussmöglichkeiten für Busleitungen, eine Anzeigefeld, welches von außerhalb des Gehäusesystem einsehbar ist, sowie nötige Kabeldurchführungen vorzugsweise als Steckverbinderteil, insbesondere für eine Busleitung auf.

Nicht benutzte Öffnungen 140 oder durchgehende Ausnehmungen 136 sind vorzugsweise durch entsprechende Dichtelemente verschließbar oder alternativ nur benutzte Öffnungen 140 und durchgehende Ausnehmungen 136 werden mittels umlaufender Sollbruchstellen bei Bedarf aus der Gehäusewand des Gehäuseteils 102 oder dem Gehäusedeckel 104 herausgebrochen.

Die Gehäuseteile 102 sind vorteilhafterweise als Gussteile gefertigt. Bei einem besonders bevorzugten Ausführungsform des Herstellungsverfahrens werden in den ersten und zweiten Seitenwänden 124, 126, der Frontseite 128, und/oder der Rückseite 130 passende Steckverbinderteile 138 und/oder Gehäuse 150 für Anschlusssteckverbinderteile angegossen oder eingegossen.

Das erfindungsgemäße Gehäusesystem 100 ist vorzugsweise für einen Umrichter vorgesehen. Dazu lassen sich die einzelnen Modul eines Umrichters, wie Gleichrichter, Wechselrichter, Zwischenkreis, Bremswiderstand, Rückspeisemodul und so weiter in je einem Gehäuseteil 102 mit Gehäusedeckel 104 ausführen.

Die Gehäuseteile 102 mit Gehäusedeckel 104 bilden jeweils gekapselte Kühlkörpermodule, welche einzeln abgeschlossen, geprüft und lagerfähig sind. Dadurch können die einzelnen Module nach den gängigen Richtlinien geprüft und von den zuständigen Behörden abgenommen werden. Ein Gehäusesystem 100, welches aus einzeln geprüften Modulen bzw. Gehäuseteilen 102 aufgebaut ist, ist dann als Ganzes schon geprüft. Somit erreicht man eine Hohe Varianz an unterschiedliche, auf spezielle Bedürfnisse abgestimmte, elektrische Vorrichtungen bei vereinfachter Zertifizierung.

Die Kühlkörpermodule sind in hoher Schutzart, wie zum Beispiel IP 65 ausführbar. Somit ist dann auch das Gehäusesystem 100 in hoher Schutzart fertigbar.

Durch die Kombinationsfähigkeit der einzelnen Module bzw. Gehäuseteilen 102 sind auf einfache Art und Weise beliebige Umrichter bzw. Gehäusesysteme 100 fertigbar.

Es ist auch möglich das Gehäusesystem mit weiteren Anbaugehäusen entsprechend zu ergänzen oder den Innenraum der Gehäuseteile 102 durch weitere Gehäuseelemente wie Steckverbinderteile oder Anbaugehäuse abzuschließen.

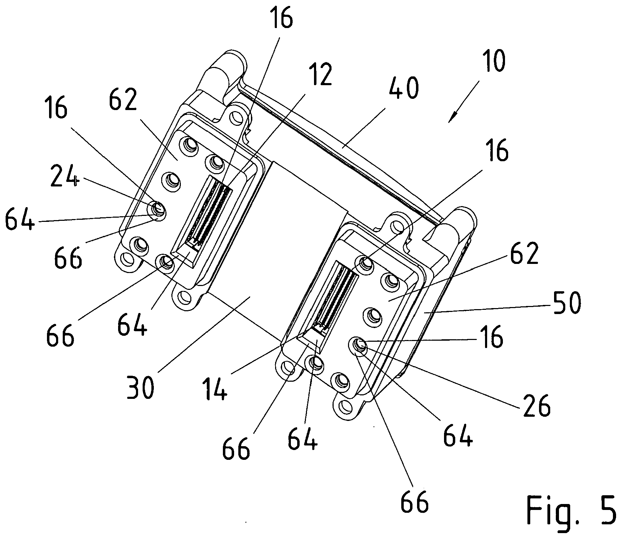

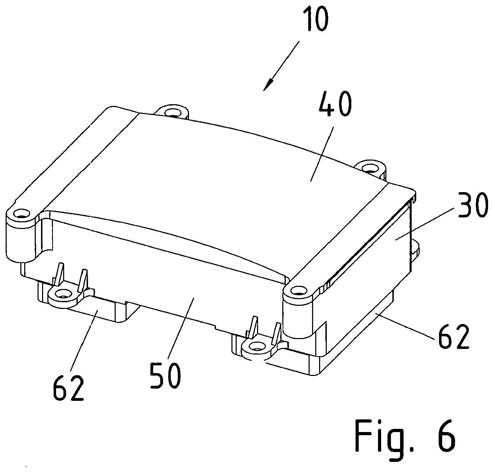

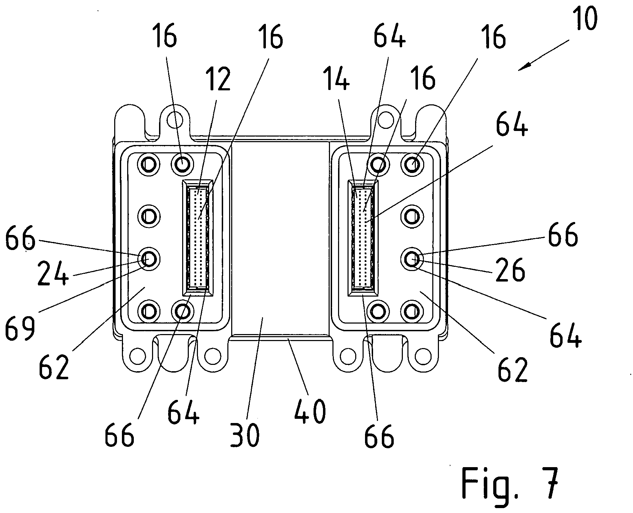

Die Figuren 5 bis 8 zeigen eine bevorzugte Ausführungsform einer Vorrichtung 10 zur elektrischen Verbindung für ein erfindungsgemäßes Gehäusesystem 100. Die Vorrichtung 10 zur elektrischen Verbindung weist ein Vorrichtungsgehäuse 30 auf. Im Vorrichtungsgehäuse 30 ist ein erstes Steckverbinderteil 12 und ein zweites Steckverbinderteil 14 angeordnet, so dass je ein Kontaktbereich 16 des ersten Steckverbinderteils 12 und des zweiten Steckverbinderteils 14 von außen zugänglichen sind.

Die Kontaktbereiche 16 sind unterschiedlich ausgeformt. Manche Kontaktbereiche 16 umfassen mehrere pinartige Kontaktstifte zur Herstellung eines elektrischen Kontaktes mit einer entsprechend ausgeführten Kontaktbuchse auf. Andere Kontaktbereiche 16 sind als buchsenartiger Zylindermantel oder entsprechend den geläufigen elektrischen Steckverbindern, wie zum Beispiel Bananenstecker, Klinkenstecker, oder ähnliches unter Berücksichtigung der geforderten Strom- und Spannungsfestigkeit ausgeführt.

Im Vorrichtungsgehäuse 30 ist das erste Steckverbinderteil 12 mit einer ersten Leiterplatte 18 fest verbunden. Die feste Verbindung ist mittels Lötverbindung, Steckverbindung, Einpressung oder ähnlichem realisiert. Ebenso ist im Vorrichtungsgehäuse 30 das zweite Steckverbinderteil 14 mit einer zweiten Leiterplatte 20 fest verbunden.

Die erste Leiterplatte 18 und die zweite Leiterplatte 20 sind jeweils im Gehäuse und relativ zum Gehäuse beweglich angeordnet. Somit weisen die erste Leiterplatte 18 und die zweite Leiterplatte 20 und mit ihnen entsprechend das erste Steckverbinderteil 12 und das zweite Steckverbinderteil 14 jeweils eine Beweglichkeit im Gehäuse auf. Somit erreicht man eine schwimmende Anordnung des ersten Steckverbinderteils 12 und des zweiten Steckverbinderteils 14 im Vorrichtungsgehäuse 30. Dies erlaubt den Ausgleich einer gröberen Toleranz bei der Fertigung der Vorrichtung 10 zur elektrischen Verbindung und insbesondere des Gehäuses 30 und eines entsprechenden Gegengehäuse mit entsprechend ausgeführten Gegenkontaktbereichen mit Gegensteckverbindern mit welchen die Steckverbinder 12, 14, 24, 26 und insbesondere die Kontaktbereiche 16 zur Herstellung einer elektrischen Verbindung zusammenwirken. Besonders Vorteilhaft ist dabei, dass auch Gussteile als Vorrichtungsgehäuse 30 und Gegengehäuse verwendbar sind.

Vorteilhafterweise ist die erste Leiterplatte 18 mit der zweiten Leiterplatte 20 im Gehäuse mittels elektrischen Leitungen 22 verbunden. Die elektrischen Leitungen 22 weisen eine gewisse Flexibilität auf. Durch die Verbindung mittels der elektrischen Leitungen 22 ist die eine relative Beweglichkeit zwischen der ersten Leiterplatte 18 und der zweiten Leiterplatte 20 gedämpft. Das heißt, dass eine von einer äußeren Kraft ausgelöste Beschleunigung der jeweiligen ersten oder zweiten Leiterplatte 18, 20 vermindert ist. Die jeweilige Beweglichkeit im Vorrichtungsgehäuse 30 der ersten und zweiten Leiterplatte 18, 20 ist aber nicht durch die elektrischen Leitungen 22 eingeschränkt.

Das erste und zweite Steckverbinderteil **(12, 14)** sind bevorzugt zu Übertragung von Datensignalen im Kleinspannungsbereich ausgeführt wie zum Beispiel als Pfostenleiste, Pfostenstecker oder Wannenstecker. Der Kleinspannungsbereich entspricht Signalen bis 50 Volt Wechselspannung oder 100 V Gleichspannung. Dafür sind die elektrischen Leitungen 22 zwischen der ersten und zweiten Leiterplatte 18, 20 vorzugsweise als ein Flachbandkabel, welches insbesondere geschirmt ist, ausgeführt. Somit ist die Vorrichtung 10 zur elektrischen Verbindung als Brücke zwischen zwei Gegengehäusen zur Übertragung von Datensignalen einsetzbar.

Bei einer bevorzugten Ausführungsform der Vorrichtung 10 zur elektrischen Verbindung ist im Vorrichtungsgehäuse 30 ein drittes Steckverbinderteil 24 auf einer dritten Leiterplatte 23 und ein viertes Steckverbinderteil 24 auf einer vierten Leiterplatte 25 im Vorrichtungsgehäuse 30 angeordnet.

Je ein Kontaktbereich 16 des dritten Steckverbinderteils 24 und vierten Steckverbinderteils 26 sind von außerhalb des Gehäuses 30 zugänglich, insbesondere zum Zusammenwirken mit entsprechend ausgeformten Gegensteckverbinderteilen. Die dritte und vierte Leiterplatte 23, 25 weisen im Vorrichtungsgehäuse 30 und relative zum Vorrichtungsgehäuse 30 jeweils eine Bewegbarkeit auf. Somit sind das dritte Steckverbinderteil 24 und das vierte Steckverbinderteil 26 im Vorrichtungsgehäuse 30 auch schwimmend angeordnet. Somit können sich das dritte Steckverbinderteil 24 und das vierte Steckverbinderteil 26 jeweils an die Position eines zugehörigen Gegensteckverbinderteils, mit welchen sie in Steckverbindung treten oder getreten sind, anpassen.

Die dritte und vierte Leiterplatte 23, 25 sind über weitere elektrische Leitungen 28, insbesondere einzelne Kupferdrähte, miteinander verbunden. Eine relative Bewegbarkeit zwischen der dritten und vierten Leiterplatte 23, 25 ist dadurch gedämpft. Die jeweilige Bewegbarkeit im Vorrichtungsgehäuse 30 der dritten und vierten Leiterplatte 23, 25 ist aber uneingeschränkt, d.h. die jeweilige Bewegbarkeit ist nicht von den weiteren elektrischen Leitungen 28 eingeschränkt.

Das dritte Steckverbinderteil 24 und das vierte Steckverbinderteil 26 sind vorteilhafterweise zur Übertragung von elektrische Leistung für Niederspannung bis 1 Kilo Volt ausgeführt. Für die weiteren elektrischen Leitungen 28 sind dafür vorzugsweise isolierte Kupferdrähte mit geeignetem Durchmesser vorgesehen.

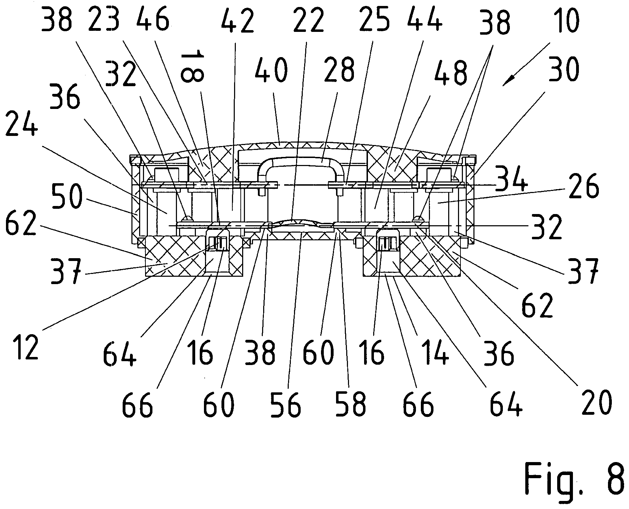

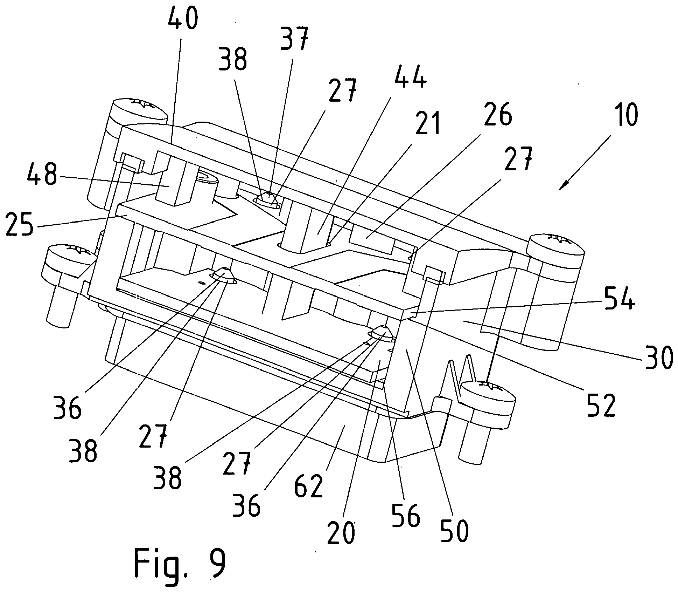

In Figur 8 und 9 ist gezeigt, dass die erste und zweite Leiterplatte 18, 20 in einer ersten Ebene 32 im Gehäuse angeordnet sind und die dritte und vierte Leiterplatte 23, 25 in einer zweiten Ebene im Gehäuse 34. Die erste Ebene 32 ist vorzugsweise von der parallel zweiten Ebene 34 beabstandet. Hierbei bedeutet Ebene nicht eine mathematisch unendlich dünne Ebene. Die Ebenendicken sind durch eine entsprechende Verkippbarkeit im Vorrichtungsgehäuse 30 der ersten und zweiten Leiterplatten 18, 20 beziehungsweise der dritten und vierten Leiterplatten 23, 25 definiert. Bei verkippten ersten bis vierten Leiterplatten 18, 20, 23, 25 weist die Ebene 32, 34 eine entsprechende Dicke auf.

Der Vorteil der Anordnung der ersten bis vierten Leiterplatten 18, 20, 23, 25 in zwei voneinander beabstandeten Ebenen 32, 34 liegt darin, das die elektrische Leistungsübertragung, zum Beispiel für die Leistung zum Antreiben eines elektrischen Motors und die Datensignale, wie zum Beispiel zur Ansteuerung eines Frequenzumrichters, sich möglichst wenig beeinflussen und Übertragungsstörungen gering bleiben.

Die Beweglichkeit und die Bewegbarkeit der ersten bis vierten Leiterplatte 18, 20, 23, 25 wird durch entsprechende Haltemittel im Vorrichtungsgehäuse 30 eingeschränkt.

Wie in Figur 8 und Figur 9 gezeigt sind die erste und zweite Leiterplatte durch mindestens je einen Haltezapfen 36, in ihrer Beweglichkeit in der ersten Ebene 32 begrenzt. Der Haltezapfen 36 ist senkrecht zur ersten Ebene 32 im Vorrichtungsgehäuse 30 angeordnet und vorzugsweise zylindrisch ausgeformt.

Der jeweilige Haltezapfen 36 ist mit einem vorzugsweise freistehenden Endabschnitt 38, durch eine entsprechende Ausnehmung 27 in der ersten beziehungsweise der zweiten Leiterplatte 18, 20 hindurchgeführt. Die entsprechende Ausnehmungen 27 weist einen größeren Umfang auf, als der Durchmesser des entsprechenden Endabschnitts 38 des jeweiligen Haltezapfens 36. Der jeweilige Haltezapfen 36 ragt aus einer Innenwand 56 des Gehäuses 30 insbesondere senkrecht hervor.

Der Haltezapfen 36 weist zwischen der ersten oder zweiten Leiterplatte 18, 20 und der Innenwand 56 einen dickeren Durchmesser auf als die zugehörige Ausnehmung 27 der ersten oder zweiten Leiterplatte 18, 20. Somit bildet der Haltezapfen 36 jeweils einen Auflagering auf dem die erste und zweite Leiterplatte 18, 20 bei entsprechender Ausrichtung des Vorrichtungsgehäuse 30 aufliegt. Als weiteres Haltemittel sind aus der Innenwand 56 herausragende Abschnitte 58 ausgebildet. Eine Stirnfläche 60 der herausragende Abschnitte liegt in einer Begrenzungsebene, welche durch die Auflageringe der Haltezapfen 36 aufgespannt ist.

Ein Endbereich des Endabschnitts 38 des Haltezapfens 36 ist als Kegelstumpfmantelfläche ausgeformt. Dies erlaubt ein einfacheres Montieren der ersten und zweiten Leiterplatte 18, 20 auf den entsprechenden Haltezapfen 36.

Gegenüber der Innenwand 56 ist das Vorrichtungsgehäuse 30 durch einen Deckel 40 gehäusebildend verschlossen. Der Deckel 40 ist mittels Schrauben mit einem Gehäuseteil des Gehäuses 30 verbunden. Das Gehäuseteil weist dafür entsprechende Gewindelöcher auf. Vorteilhafterweise sind die Gewindelöcher in an einer Außenwand des Gehäuseteils angeformte Ausstülpungen eingebracht.

Der Deckel 40 bildet eine Innenfläche des Gehäuses 30, welche über eine längere Seite des im Wesentlichen quaderförmigen Gehäuses 30 gewölbte ist. Von der gewölbten Fläche stehen ein erster Haltestempel 42 und ein zweiter Haltestempel 44 senkrecht zur ersten und zweiten Ebene 32, 34 in den Innenraum des Gehäuses 30 hinein. Als weitere Haltemittel begrenzen der erste und zweite Haltestempel 42, 44 die Beweglichkeit der ersten beziehungsweise zweiten Leiterplatte 18, 20 in Richtung hin zum Deckel 40.

Auf analoge Weise sind die dritte und vierte Leiterplatte 23, 25 durch weitere Haltezapfen 37 und einen dritten und einen vierten Haltestempel 46, 48 in ihrer Bewegbarkeit im Vorrichtungsgehäuse 30 begrenzt. Die weiteren Haltezapfen 37 und der dritte und vierte Haltestempel 46, 48 sind in ihrer Länge entsprechend angepasst. Die weiteren Haltezapfen 37 sind außer ihrer Länge analog zu den Haltezapfen 36 ausgeformt.

Der erste und zweite Haltestempel 42, 44 ragen durch Öffnungen 21 in der dritten beziehungsweise vierten Leiterplatte 23, 25 hindurch. Die Öffnungen 21 weisen einen entsprechend großen Durchmesser auf, damit die Bewegbarkeit der dritten und vierten Leiterplatte 23, 25 durch den ersten und zweiten Haltestemple 42, 44 nicht eingeschränkt ist.

Der erste, zweite, dritte und vierte Haltestempel 42, 44, 46, 48 sind vorzugsweise einstückig mit dem Deckel 40 ausgeformt. Stirnflächen des ersten und zweiten Haltestempels, 42, 44 und Stirnflächen der dritten und vierten Haltestemple 46, 48 liegen jeweils in einer deckelseitigen Begrenzungsebene. Diese deckelseitigen Begrenzungsebenen und die durch den Auflagering der zugehörigen Haltezapfen 36 aufgespannten Begrenzungsebene beziehungsweise eine weitere durch die Auflagering der weiteren Haltezapfen 37 aufgespannten Begrenzungsebene sind parallel zueinander und weisen einen Abstand voneinander auf. Dieser Abstand entspricht jeweils vorzugsweise der doppelten Leiterplattendicke der ersten und zweiten Leiterplatte 18, 20 beziehungsweise der dritten und vierten Leiterplatte 23, 25. Somit ist die Beweglichkeit der ersten und zweiten Leiterplatte 18, 20 und die Bewegbarkeit der dritten und vierten Leiterplatte 23, 25 in Richtung senkrecht zu den jeweiligen Haltestempeln 42, 44, 46, 48 begrenzt.

Das Vorrichtungsgehäuse 30 weist eine umlaufende Wand 50 auf. Auf der umlaufenden Wand 50 liegt der Deckel 40 mit einer umlaufenden, vorzugsweise angespritzten, Dichtung auf. Als weitere Haltemittel für die dritte und vierte Leiterplatte 23, 25 ist in der umlaufenden Wand 50 eine umlaufende Stufe 52 eingearbeitet. Aus einer Einsteckrichtung der Vorrichtung gesehen überlappt ein jeweiliger Randbereich 54 der dritten und vierten Leiterplatte 23, 25 mit der umlaufenden Stufe 52. Die umlaufende Stufe 52 liegt in der durch die Auflageringe der der dritten und vierten Leiterplatte 23, 25 zugeordneten Haltezapfen 36 aufgespannten Ebene.

Das Maß der Beweglichkeit und der Bewegbarkeit und somit ein Maß einer Fangfähigkeit des jeweiligen ersten, zweiten, dritten und vierten Steckverbinderteils 12, 14, 24, 26 ist bestimmt durch die Toleranzen bei der Fertigung des zugehörigen Steckverbindergegenstücks.

Am Vorrichtungsgehäuse 30 sind vorzugsweise an der gleichen Seite des Gehäuses 30 zwei Einführhilfen 62 angeformt. Die Einführhilfen 62 weisen passende Ausnehmungen 64 auf. In die passenden Ausnehmungen 64 ragen vom Innenraum des Gehäuses 30 aus das erste, zweite , dritte und vierte Steckverbinderteil 12, 14, 24, 26 hinein. Die passenden Ausnehmungen 64 sind so ausgeformt, dass sie die Beweglichkeit und die Bewegbarkeit der mit den ersten, zweiten, dritten und vierten Steckverbinderteilen 12, 14, 24, 26 verbundenen ersten, zweiten dritten und vierten Leiterplatte 18, 20, 23, 25 nicht einschränken.

Die Einführhilfen 62 sind im Wesentlichen quaderförmig und direkt an das Vorrichtungsgehäuse 30 angeformt bzw. einstückig mit dem Vorrichtungsgehäuse 30 ausgeführt. Die vier Ecken der Einführhilfen sind abgerundet. Die Einführhilfen ragen über das erste, zweite, dritte und vierte Steckverbinderteil 12, 14, 24, 26 hinaus, bzw. das erste, zweite, dritte und vierte Steckverbinderteil 12, 14, 24, 26 sind in den passenden Ausnehmungen 64 versteckt. Dies erlaubte eine sichere Verbindung der Vorrichtung 10 zur elektrischen Verbindung, ohne dass spannungsführende Elemente offen liegen.

Vorzugsweise sind mehrere dritte, und vierte Steckverbinderteile 24, 26 in passenden Ausnehmungen 64 in den Einführhilfen 62 angeordnet um zum Beispiel die drei Phasen und eine Erdung einer dreiphasigen Wechselspannung mittels der Vorrichtung 10 zur elektrischen Verbindung zu übertragen. Dabei sind alle dritten Steckverbinderteile 24 mit der dritten Leiterplatte 23 verbunden und alle vierten Steckverbinderteile 26 mit der vierten Leiterplatte 25. Somit sind mehrere diskrete Steckverbinderteile mit einer einzigen im Vorrichtungsgehäuse 30 schwimmend angeordneten Leiterplatte verbunden.

An den von dem Gehäuse abgewandten Stirnflächen der Einführhilfen 62 sind die um die passenden Ausnehmungen 64 herumlaufenden Kanten abgeschrägt als Fase 66 ausgeführt. Die Fase 66 bildet so für jede passende Ausnehmung 64 einen Fangtrichter zur Aufnahme des entsprechenden Gegensteckverbinderteils.

Die Vorrichtung 10 zur elektrischen Verbindung erlaubt eine vielfältige elektrische Verbindung für verschieden Signalarten in einem sicheren, abgeschirmten Vorrichtungsgehäuse 30, welches in Verbindung mit der entsprechend ausgeführten elektrischen Vorrichtung mit welcher die Vorrichtung 10 zur elektrischen Verbindung in Wirkverbindung steht, in hoher Schutzart ausführbar ist, wie zum Beispiel Staub und Strahlwasser geschützt oder ähnliches. Die Vorrichtung zur elektrischen Verbindung 10 erlaubt auch eine mechanische Stabilisierung von zwei einzelnen elektrischen Vorrichtungen, zwischen denen die Vorrichtung 10 zur elektrischen Verbindung eine elektrische Verbindung bewirkt.

Zur besseren Verbindung der Vorrichtung 10 zur elektrischen Verbindung mit den elektrischen Vorrichtungen weist das Gehäuseteil angeformt Laschen auf, durch welche weitere Schrauben, insbesondere Rändelschrauben zur werkzeuglosen Montage führbar sind. Die weiteren Schrauben sind in entsprechende Gewindelöcher in den elektrischen Vorrichtungen schraubbar. Die zu den elektrischen Vorrichtungen gerichtet Seite der Vorrichtung 10 zur elektrischen Verbindung weist die Einführhilfen auf und ein um die Einführhilfen herumgeführtes Dichtungselement. Das Dichtungselement ist zwischen den elektrischen Vorrichtungen und dem Vorrichtungsgehäuse 30 einklemmbar angeordnet. Die Klemmung der Dichtungselemente wird vorzugsweise durch das Anziehen der weiteren Schrauben erreicht.

### Bezugszeichenliste

- 10: Vorrichtung zur elektrischen Verbindung
- 12: erstes Steckverbinderteil
- 14: zweites Steckverbinderteil
- 16: Kontaktbereich
- 18: erste Leiterplatte
- 20: zweite Leiterplatte
- 21: Öffnung
- 22: elektrische Leitungen
- 24: drittes Steckverbinderteil
- 26: viertes Steckverbinderteil
- 27: Ausnehmung
- 28: weitere elektrische Leitungen
- 30: Vorrichtungsgehäuse
- 32: erste Ebene
- 34: zweite Ebene
- 36: Haltezapfen
- 37: weitere Haltezapfen
- 38: Endabschnitt
- 40: Deckel
- 42: erste Haltestempel
- 44: zweite Haltestempel
- 46: dritter Haltestempel
- 48: vierter Haltestempel
- 50: umlaufende Wand
- 52: umlaufende Stufe
- 54: Randbereich
- 56: Innenwand
- 58: herausragende Abschnitte
- 60: Stirnfläche
- 62: Einführhilfen
- 64: passende Ausnehmungen
- 66: Fase
- 100: Gehäusesystem
- 102: Gehäuseteil
- 104: Gehäusedeckel
- 106: Innenraum
- 108: erste Art von Ausformungen
- 109: zweite Art von Ausnehmungen
- 110: erste Art von komplementäre Ausformungen
- 111: zweite Art von komplementären Ausformungen
- 112: erstes Halteelement
- 114: zweites Halteelement
- 116: Ausnehmung
- 118: Befestigungselement
- 120: C-Schiene
- 122: Boden
- 123: Abstandszapfen
- 124: erste Seitenwand
- 126: zweite Seitenwand
- 127: Einschubkanäle
- 128: Frontseite
- 129: quaderförmige Ausstülpungen
- 130: Rückseite
- 132: Ausstülpungen
- 134: korrespondierende Ausnehmungen
- 136: durchgehende Ausnehmungen
- 138: passende Steckverbinderteile
- 140: Öffnungen
- 142: Hakenelement
- 144: Zapfenelement
- 146: Kühlrippen
- 148: weiterer Gehäusedeckel
- 149: Verbindungselement
- 150: Gehäuse für Anschlusssteckverbinderteile

## Patentansprüche

1. Gehäusesystem,
welches mindestens zwei Gehäuseteile (102) mit je einem zugehörigen Gehäusedeckel (104) umfasst,
**wobei** jedes der Gehäuseteile (102) wannenförmig ausgeformt ist,
wodurch das Gehäuseteil (102) und der zugehörige Gehäusedeckel (104) je einen Innenraum einfassen,
und je zwei Gehäuseteile (102) über eine Vorrichtung zur elektrischen Verbindung, welche als Steckmodul mit einem ersten und zweiten Steckverbinderteil (12, 14) ausgeführt ist, elektrisch und/oder mechanisch lösbar verbunden sind,
**wobei die Vorrichtung zur elektrischen Verbindung ein erstes Steckverbinderteil (12) und ein zweites Steckverbinderteil (14) aufweist, welche mit je einem von außen zugänglichen Kontaktbereich in einem Vorrichtungsgehäuse (30) angeordnet sind,**
**wobei das erste Steckverbinderteil (12) mit einer ersten Leiterplatte** (18) **fest verbunden ist**
**und das zweite Steckverbinderteil (14) mit einer zweiten Leiterplatte (20) fest verbunden ist, wobei die erste Leiterplatte (18) und die zweite Leiterplatte (20) jeweils im Vorrichtungsgehäuse (30) und relativ zum Vorrichtungsgehäuse (30) beweglich angeordnet sind und somit jeweils eine Beweglichkeit im Vorrichtungsgehäuse (30) aufweisen,**
**wobei die Beweglichkeit der** Leiterplatten (18,20) **durch Haltezapfen (36) im Vorrichtungsgehäuse eingeschränkt wird, wobei die Endabschnitte der Haltezapfen (36) durch Ausnehmungen** (27) **in den Leiterplatten geführt werden und die Ausnehmungen einen größeren Durchmesser als die Endabschnitte der Haltezapfen (36) aufweisen,**
**wobei die Steckverbinderteile (12,14) Kontaktbereiche aufweisen, die zur Herstellung einer elektrischen Verbindung mit Gegensteckverbindern mit Gegenkontaktbereichen der Gehäuseteile** (102) **zusammenwirken,**
**wobei die ersten und die zweite Leiterplatte (18, 20) mittels elektrischer Leitungen (22) verbunden sind, die eine gewisse Flexibilität aufweisen.**

2. Gehäusesystem nach Anspruch 1,
**dadurch gekennzeichnet, dass**
die Gehäuseteile (102) einen Boden und eine erste Seitenwand (124) und eine der ersten Seitenwand (124) gegenüberliegende zweite Seitenwand (126)sowie eine die erste und zweite Seitenwand (124, 126) verbindende Frontseite (128) und eine entsprechende der Frontseite (128) gegenüberliegende Rückseite (130) aufweisen.

3. Gehäusesystem nach Anspruch 2,
**dadurch gekennzeichnet, dass**
in der Rückseite (130) des oder der Gehäuseteile (102) Öffnungen angeordnet sind, welche vorzugsweise in an die Seitenwänden (124, 126) angrenzenden Endbereichen der Rückseite (130) angeordnet sind.

4. Gehäusesystem nach einem der vorangegangenen Ansprüche,
**dadurch gekennzeichnet, dass**
am Vorrichtungsgehäuse (30) zwei Einführhilfen angeformt sind, in welchen die ersten und zweiten und/oder ein drittes und ein viertes Steckverbinderteile (24, 26) zumindest teilweise in passenden Ausnehmungen beweglich angeordnet sind,

5. Gehäusesystem nach den Ansprüchen 3 oder 4,
**dadurch gekennzeichnet, dass**
im eingesteckten Zustand der Vorrichtung zur elektrischen Verbindung die Einführhilfen in die Öffnungen zweier benachbarter Gehäuseteile (102) formschlüssig eingreifen und das Vorrichtungsgehäuse (30) die Öffnungen (140) abdichtend verschließt.

6. Gehäusesystem nach einem der Ansprüche 1 bis 5,
**dadurch gekennzeichnet, dass**
die erste Leiterplatte (18) mit der zweiten Leiterplatte (20) im Vorrichtungsgehäuse (30) mittels elektrischen Leitungen (22), insbesondere einem Flachbandkabel, verbunden ist, wobei eine relative Beweglichkeit der ersten Leiterplatte (18) zur zweiten Leiterplatte (20) im Vorrichtungsgehäuse (30) durch die elektrischen Leitungen (22) gedämpft und/oder uneingeschränkt ist.

7. Gehäusesystem nach Anspruch 4,
**dadurch gekennzeichnet, dass**
das dritte Steckverbinderteil (24) auf einer dritten Leiterplatte und das vierte Steckverbinderteil (26) auf einer vierten Leiterplatte im Vorrichtungsgehäuse (30) angeordnet sind, wobei je ein Kontaktbereich des dritten und vierten Steckverbinderteils (24, 26) von außerhalb des Vorrichtungsgehäuses (30) zugänglich ist und die dritte und vierte Leiterplatte im Vorrichtungsgehäuse (30) jeweils eine Bewegbarkeit aufweisen und über weitere elektrische Leitungen (22), insbesondere einzelne Kupferdrähte, miteinander verbunden sind, insbesondere so dass eine relative Bewegbarkeit zwischen der dritten und vierten Leiterplatte gedämpft und/oder uneingeschränkt ist.

8. Gehäusesystem nach Anspruch 5 bis 7,
**dadurch gekennzeichnet, dass**
das erste und zweite Steckverbinderteil (12, 14) und/oder das dritte und vierte Steckverbinderteil (24, 26) jeweils in ein passendes Gegensteckverbinderteil in jeweils benachbarten Gehäuseteilen (102) eingreifen.

9. Gehäusesystem nach Anspruch 2 und 8,
**dadurch gekennzeichnet, dass**
**die passenden Gegensteckverbinderteile hinter jeweils zwei Öffnungen (140) in jeweiligen Innenräumen** angeordnet sind, wobei die Gegensteckverbinderteile in den jeweiligen Innenräumen über eine Rückplatte miteinander verbunden sind.

10. Gehäusesystem nach einem der Ansprüche 4 bis 9,
**dadurch gekennzeichnet, dass**
das erste und zweite Steckverbinderteil (12, 14) zur Übertragung von Datensignalen im Kleinspannungsbereich ausgeführt sind sowie das dritte und vierte Steckverbinderteil (24, 26) zur Übertragung von elektrischer Leistung im Niedervoltbereich ausgeführt sind.

11. Gehäusesystem nach einem der vorangegangenen Ansprüche,
**dadurch gekennzeichnet, dass**
je zwei Gehäuseteile (102) über Ausformungen an einem der zwei Gehäuseteile (102) und dazu komplementäre Ausformungen (108, 109) am anderen der zwei Gehäuseteile (102) miteinander mechanisch verbunden sind.

12. Gehäusesystem nach Anspruch 4,
**dadurch gekennzeichnet, dass**
die erste und zweite Leiterplatte (18, 20) beziehungsweise die dritte und vierte Leiterplatte im Vorrichtungsgehäuse (30) durch entsprechende Haltemittel in ihrer Beweglichkeit beziehungsweise Bewegbarkeit beschränkt sind.

13. Gehäusesystem nach Anspruch 4 oder 12,
**dadurch gekennzeichnet, dass**
in der Frontseite (128) durchgehende Ausnehmungen angeordnet sind, in welchen insbesondere passende Steckverbinderteile angeordnet sind und vorzugsweise die erste und zweite Leiterplatte (18, 20) in einer ersten Ebene im Vorrichtungsgehäuse (30) angeordnet sind und die dritte und vierte Leiterplatte (24, 26) in einer zweiten Ebene im Vorrichtungsgehäuse angeordnet sind, wobei die erste Ebene parallel beabstandet zur zweiten Ebene liegt.

14. Gehäusesystem nach einem der vorangegangenen Ansprüche,
**dadurch gekennzeichnet, dass**
die Frontseite (128) und die Rückseite (130) in einem bodenseitigen der ersten Seitenwand (124) zugewandten Eckbereich je eine Hakenelement aufweist, welches über die erste Seitenwand (124) übersteht und in einem bodenseitigen der zweiten Seitenwand (126) zugeordneten Eckbereich eine senkrecht auf der Frontseite (128) beziehungsweise der Rückseite (130) abstehendes Zapfenelement (144) aufweist, wobei im zusammengebauten Zustand der mehreren Gehäuseteile (102) das Hakenelement in das jeweilig zugeordnete Zapfenelement (144) des benachbarten Gehäuseteils eingreift.

## Claims

1. A housing system,
which comprises at least two housing parts (102) each with an associated housing cover (104), wherein each of the housing parts (102) is of trough-shaped form,
whereby the housing part (102) and the associated housing cover (104) each enclose an inner space, and each two housing parts (102) are detachably connected electrically and/or mechanically via a device for electrical connection which is in the form of a plug-in module having a first and second plug-in connector part (12, 14),
wherein the device for electrical connection has a first plug-in connector part (12) and a second plug-in connector part (14), which are arranged in a device housing (30) by means of a respective contact region accessible from the exterior,
wherein the first plug-in connector part (12) is securely connected to a first printed circuit board (18)
and the second plug-in connector part (14) is securely connected to a second printed circuit board (20), wherein the first printed circuit board (18) and the second printed circuit board (20) are each arranged to be movable in the device housing (30) and relative to the device housing (30) and consequently each have movability in the device housing (30),
wherein the movability of the printed circuit boards (18, 20) is restricted by holding pins (36) in the device housing, wherein the end portions of the holding pins (36) are passed through cut-outs (27) in the printed circuit boards and the cut-outs have a larger diameter than the end portions of the holding pins (36),
wherein the plug-in connector parts (12, 14) have contact regions which in order to produce an electrical connection with counter plug-in connectors cooperate with counter contact regions of the housing parts (102),
wherein the first and the second printed circuit board (18, 20) are connected by means of electrical lines (22) which have a certain flexibility.

2. A housing system according to claim 1,
**characterised in that**
the housing parts (102) have a bottom and a first side wall (124) and a second side wall (126) facing the first side wall (124), and also a front side (128) connecting the first and second side wall (124, 126) and a corresponding rear side (130) opposite the front side (128).

3. A housing system according to claim 2,
**characterised in that**
openings are arranged in the rear side (130) of the housing part(s) (102), which openings are preferably arranged in end regions, adjoining the side walls (124, 126), of the rear side (130).

4. A housing system according to any one of the preceding claims,
**characterised in that**
two insertion aids are formed on the device housing (30), in which the first and second and/or a third and a fourth plug-in connector part (24, 26) are at least partially arranged in matching cut-outs in a movable manner.

5. A housing system according to claims 3 or 4,
**characterised in that**
in the inserted state of the device for electrical connection, the insertion aids engage the openings of two adjacent housing parts (102) in a form-locked manner and the device housing (30) closes the openings (140) in a sealing manner.

6. A housing system according to any one of claims 1 to 5,
**characterised in that**
the first printed circuit board (18) is connected to the second printed circuit board (20) in the device housing (30) by means of electrical lines (22), in particular a flat cable, wherein a relative movability of the first printed circuit board (18) in relation to the second printed circuit board (20) in the device housing (30) is damped and/or unrestricted by the electrical lines (22).

7. A housing system according to claim 4,
**characterised in that**
the third plug-in connector part (24) is arranged on a third printed circuit board and the fourth plug-in connector part (26) is arranged on a fourth printed circuit board in the device housing (30), wherein a respective contact region of the third and fourth plug-in connector part (24, 26) is accessible from the exterior of the device housing (30) and the third and fourth printed circuit board in the device housing (30) each have mobility and are connected to one another via further electrical lines (22), in particular individual copper wires, in particular so that a relative mobility between the third and fourth printed circuit board is damped and/or unrestricted.

8. A housing system according to claim 5 to 7,
**characterised in that**
the first and second plug-in connector part (12, 14) and/or the third and fourth plug-in connector part (24, 26) each engage a matching counter plug-in connector part in adjacent housing parts (102) in each case.

9. A housing system according to claim 2 and 8,
**characterised in that**
the matching counter plug-in connector parts are arranged behind in each case two openings (140) in respective inner spaces, wherein the counter plug-in connector parts are connected to one another in the respective inner spaces via a back plate.

10. A housing system according to any one of claims 4 to 9,
**characterised in that**
the first and second plug-in connector part (12, 14) are designed for transmitting data signals in the extra-low voltage range and the third and fourth plug-in connector part (24, 26) are designed for transmitting electrical power in the low-voltage range.

11. A housing system according to any one of the preceding claims,
**characterised in that**
pairs of housing parts (102) are mechanically connected to one another via formations at one of the two housing parts (102) and complementary formations (108, 109) at the other of the two housing parts (102).

12. A housing system according to claim 4,
**characterised in that**
the first and second printed circuit board (18, 20) or the third and fourth printed circuit board in the device housing (30) are restricted in their mobility or movability by appropriate holding means.

13. A housing system according to claim 4 or 12,
**characterised in that**
in the front side (128) there are arranged through cut-outs in which there are arranged in particular matching plug-in connector parts and preferably the first and second printed circuit board (18, 20) are arranged in a first plane in the device housing (30) and the third and fourth printed circuit board (24, 26) in a second plane in the device housing, wherein the first plane lies parallel to the second plane, at a distance therefrom.

14. A housing system according to any one of the preceding claims,
**characterised in that**
the front side (128) and the rear side (130) each have a hook element in a bottom-side corner region (124) facing the first side wall (126), which hook element projects beyond the first side wall (124) and in a bottom-side corner region associated with the second side wall (126) has a pin element (144) projecting perpendicularly on the front side (128) or the rear side (130) as the case may be, wherein the hook element engages the respective associated pin element (144) of the adjacent housing part in the assembled state of the plurality of housing parts (102).

## Revendications

1. Système de boîtier
comprenant au moins deux parties de boîtier (102) respectivement dotées d'un couvercle de boîtier (104) associé,
chacune desdites parties de boîtier (102) étant réalisée en forme de cuvette,
de telle manière que ladite partie de boîtier (102), et le couvercle de boîtier (104) associé, circonscrivent respectivement un espace interne,
et deux parties de boîtier (102) respectives étant reliées électriquement et/ou mécaniquement de manière dissociable, par l'intermédiaire d'un dispositif dévolu à la connexion électrique et réalisé sous la forme d'un module emboîtable doté de première et deuxième parties (12, 14) de connexion enfichable,
ledit dispositif, dévolu à la connexion électrique, comportant une première partie (12) de connexion enfichable et une deuxième partie (14) de connexion enfichable, qui sont logées dans un carter (30) dudit dispositif par une zone respective de contact accessible de l'extérieur,
ladite première partie (12) de connexion enfichable étant reliée rigidement à une première plaquette imprimée (18)
et ladite deuxième partie (14) de connexion enfichable étant reliée rigidement à une deuxième plaquette imprimée (20), ladite première plaquette imprimée (18) et ladite deuxième plaquette imprimée (20) étant respectivement logées dans le carter (30) du dispositif, de façon mobile par rapport audit carter (30) du dispositif, de sorte qu'elles sont respectivement douées de mobilité dans ledit carter (30) du dispositif,
la mobilité des plaquettes imprimées (18, 20) étant restreinte par des tétons d'arrêt (36), dans le carter du dispositif, les zones d'extrémité desdits tétons d'arrêt (36) étant guidées à travers des évidements (27) pratiqués dans lesdites plaquettes imprimées, et lesdits évidements présentant un diamètre supérieur à celui desdites zones d'extrémité desdits tétons d'arrêt (36),
sachant que les parties (12, 14) de connexion enfichable sont munies de zones de contact coopérant avec des régions de contact complémentaires, sur les parties de boîtier (102), en vue d'établir une jonction électrique avec des connecteurs enfichables complémentaires, lesdites première et deuxième plaquettes imprimées (18, 20) étant raccordées au moyen de conducteurs électriques (22) présentant une certaine flexibilité.

2. Système de boîtier selon la revendication 1,
**caractérisé par le fait que**
les parties de boîtier (102) comprennent un fond, une première paroi latérale (124) et une seconde paroi latérale (126) pointant à l'opposé de ladite première paroi latérale (124), ainsi qu'une face frontale (128) reliant lesdites première et seconde parois latérales (124, 126), et une face postérieure correspondante (130) qui pointe à l'opposé de ladite face frontale (128).

3. Système de boîtier selon la revendication 2,
**caractérisé par le fait que**
des orifices pratiqués dans la face postérieure (130) de la, ou des partie(s) de boîtier (102) sont disposés, de préférence, dans des régions extrêmes de ladite face postérieure (130) qui sont limitrophes des parois latérales (124, 126).

4. Système de boîtier selon l'une des revendications précédentes,
**caractérisé par le fait que**
deux auxiliaires d'insertion, dans lesquels les première et deuxième, et/ou des troisième et quatrième parties (24, 26) de connexion enfichable sont au moins partiellement logées dans des évidements appropriés, avec faculté de mouvement, sont ménagés sur le carter (30) du dispositif.

5. Système de boîtier selon les revendications 3 ou 4,
**caractérisé par le fait**
**qu'**à l'état emboîté du dispositif dévolu à la connexion électrique, les auxiliaires d'insertion pénètrent, par complémentarité de formes, dans les orifices de deux parties de boîtier (102) voisines, et le carter (30) du dispositif occulte lesdits orifices (140) avec effet d'étanchement.

6. Système de boîtier selon l'une des revendications 1 à 5,
**caractérisé par le fait que**
la première plaquette imprimée (18) est raccordée à la deuxième plaquette imprimée (20), dans le carter (30) du dispositif, au moyen de conducteurs électriques (22) se présentant notamment comme un câble plat, une mobilité relative de ladite première plaquette imprimée (18) par rapport à ladite deuxième plaquette imprimée (20) étant atténuée et/ou non restreinte par lesdits conducteurs électriques (22) dans ledit carter (30) du dispositif.

7. Système de boîtier selon la revendication 4,
**caractérisé par le fait que**
la troisième partie (24) de connexion enfichable est disposée sur une troisième plaquette imprimée et la quatrième partie (26) de connexion enfichable est disposée sur une quatrième plaquette imprimée, dans le carter (30) du dispositif, une zone respective de contact desdites troisième et quatrième parties (24, 26) de connexion enfichable étant accessible depuis l'extérieur dudit carter (30) du dispositif, lesdites troisième et quatrième plaquettes imprimées étant respectivement douées de mobilité dans ledit carter (30) du dispositif, et étant raccordées l'une à l'autre par l'intermédiaire de conducteurs électriques supplémentaires (22), en particulier des fils de cuivre individuels, notamment de façon telle qu'une mobilité relative desdites troisième et quatrième plaquettes imprimées soit atténuée et/ou non restreinte.

8. Système de boîtier selon les revendications 5 à 7,
**caractérisé par le fait que**
les première et deuxième parties (12, 14) de connexion enfichable et/ou les troisième et quatrième parties (24, 26) de connexion enfichable pénètrent à chaque fois, dans des parties de boîtier (102) respectivement voisines, dans une partie de connexion enfichable complémentaire et appropriée.

9. Système de boîtier selon les revendications 2 et 8,
**caractérisé par le fait que**
les parties de connexion enfichable, complémentaires et appropriées, sont respectivement disposées derrière deux orifices (140), dans des espaces internes respectifs, lesdites parties complémentaires de connexion enfichable étant mutuellement raccordées, dans lesdits espaces internes respectifs, par l'intermédiaire d'une platine postérieure.

10. Système de boîtier selon l'une des revendications 4 à 9,
**caractérisé par le fait que**
les première et deuxième parties (12, 14) de connexion enfichable sont réalisées en vue de la transmission de signaux de données dans la plage de faible tension, de même que les troisième et quatrième parties (24, 26) de connexion enfichable sont réalisées en vue de la transmission de puissance électrique dans la plage de basse tension.

11. Système de boîtier selon l'une des revendications précédentes,
**caractérisé par le fait que**
deux parties de boîtier (102) respectives sont reliées mécaniquement l'une à l'autre par l'intermédiaire de profilages, sur l'une des deux parties de boîtier (102), et de profilages complémentaires (108, 109) sur l'autre desdites deux parties de boîtier (102).

12. Système de boîtier selon la revendication 4,
**caractérisé par le fait que**
la mobilité, respectivement l'aptitude au mouvement des première et deuxième plaquettes imprimées (18, 20), respectivement des troisième et quatrième plaquettes imprimées, est restreinte par des moyens d'arrêt correspondants dans le carter (30) du dispositif.

13. Système de boîtier selon la revendication 4 ou 12,
**caractérisé par le fait que**
des évidements ininterrompus, pratiqués dans la face frontale (128), renferment notamment des parties appropriées de connexion enfichable, sachant que, de préférence, les première et deuxième plaquettes imprimées (18, 20) sont situées dans un premier plan, dans le carter (30) du dispositif, et les troisième et quatrième plaquettes imprimées (24, 26) se trouvent dans un second plan, dans ledit carter du dispositif, ledit premier plan étant parallèlement espacé dudit second plan.

14. Système de boîtier selon l'une des revendications précédentes,
**caractérisé par le fait que**
la face frontale (128) et la face postérieure (130) sont pourvues, dans une zone d'angle située côté fond et tournée vers la première paroi latérale (124), d'un élément respectif du type crochet qui dépasse au-delà de ladite première paroi latérale (124) et présente, dans une zone d'angle située côté fond et tournée vers la seconde paroi latérale (126), un élément (144) du type tenon faisant perpendiculairement saillie sur ladite face frontale (128), respectivement sur ladite face postérieure (130), sachant qu'à l'état assemblé des multiples parties de boîtier (102), ledit élément du type crochet pénètre dans l'élément (144) du type tenon de la partie de boîtier voisine, respectivement associé.
